(19) Europäisches Patentamt
European Patent Office
Office européen des brevets

(11) **EP 4 286 082 B1**

(12) **EUROPEAN PATENT SPECIFICATION**

(45) Date of publication and mention
of the grant of the patent:
**13.08.2025 Bulletin 2025/33**

(21) Application number: **21944115.1**

(22) Date of filing: **02.06.2021**

(51) International Patent Classification (IPC):
*C23C 14/06* (2006.01)    *C23C 30/00* (2006.01)
*C23C 14/02* (2006.01)    *C23C 14/32* (2006.01)
*C23C 14/58* (2006.01)    *C04B 41/00* (2006.01)
*C04B 41/50* (2006.01)    *C04B 41/52* (2006.01)
*C04B 41/89* (2006.01)    *C23C 28/04* (2006.01)
*C04B 41/90* (2006.01)

(52) Cooperative Patent Classification (CPC):
(C-Sets available)
**C23C 14/325; C04B 41/009; C04B 41/5001;
C04B 41/52; C04B 41/89; C04B 41/90;
C23C 14/027; C23C 14/0605; C23C 14/588;
C23C 28/044; C23C 30/005**            (Cont.)

(86) International application number:
**PCT/JP2021/021007**

(87) International publication number:
**WO 2022/254611 (08.12.2022 Gazette 2022/49)**

(54) **CUTTING TOOL**

SCHNEIDWERKZEUG

OUTIL DE COUPE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**06.12.2023 Bulletin 2023/49**

(73) Proprietors:
• **Sumitomo Electric Hardmetal Corp.**
**Itami-shi, Hyogo 664-0016 (JP)**
• **SUMITOMO ELECTRIC INDUSTRIES, LTD.**
**Osaka-shi, Osaka 541-0041 (JP)**

(72) Inventors:
• **TABAYASHI, Daiji**
**Itami-shi, Hyogo 664-0016 (JP)**

• **FUKUI, Haruyo**
**Itami-shi, Hyogo 664-0016 (JP)**
• **UEMURA, Shigeaki**
**Osaka-shi, Osaka 541-0041 (JP)**

(74) Representative: **Boult Wade Tennant LLP**
**Salisbury Square House
8 Salisbury Square
London EC4Y 8AP (GB)**

(56) References cited:
WO-A1-2018/101347    JP-A- 2003 062 705
JP-A- 2007 083 382    JP-A- 2009 006 470
JP-A- 2009 006 470    JP-A- 2009 061 540
JP-A- 2015 063 714    US-A1- 2003 049 083

**(Cont. next page)**

(52) Cooperative Patent Classification (CPC): (Cont.)

    C-Sets
**C04B 41/009, C04B 35/10;**
**C04B 41/009, C04B 35/5626;**
**C04B 41/009, C04B 35/565;**

**C04B 41/009, C04B 35/5831;**
**C04B 41/5001, C04B 41/52, C04B 41/4529;**
**C04B 41/52, C04B 41/5077, C04B 41/4529;**
**C04B 41/52, C04B 41/515, C04B 41/4529,**
**C04B 41/522**

## Description

TECHNICAL FIELD

The present disclosure relates to a cutting tool.

BACKGROUND ART

Hard carbon films such as amorphous carbon and diamond-like carbon are used as coating materials for cutting tools, metal molds, and machine components because of their excellent wear resistance and lubricity.
Japanese Patent Laying-Open No. 2003-62706 (PTL 1) discloses an amorphous carbon covered tool comprising a base material composed of WC base and an amorphous carbon film that covers the base material.
WO 2016/190443 (PTL 2), JP2007083382A and JP2009006470A disclose a cutting tool equipped with a base material and a DLC layer positioned on the surface of the base material and containing diamond-like carbon.

CITATION LIST

PATENT LITERATURE

PTL 1: Japanese Patent Laying-Open No. 2003-62706
PTL 2: WO 2016/190443

SUMMARY OF INVENTION

A cutting tool of the present invention is defined in the appended claims.

BRIEF DESCRIPTION OF DRAWINGS

Fig. 1 is a cross-sectional view of an example of a cutting tool according to one embodiment of the present disclosure.
Fig. 2 is a cross-sectional view of another example of a cutting tool according to one embodiment of the present disclosure.
Fig. 3 shows an example of the XANES spectrum of a first region of a hard carbon film of a cutting tool according to one embodiment of the present disclosure.
Fig. 4 is a drawing substitute photograph showing an example of a dark field image obtained by observing a cross section of a cutting tool according to one embodiment of the present disclosure, using a high angle annular dark field scanning transmission electron microscope.
Fig. 5 is a schematic diagram showing an example of a film forming apparatus used in the production of a cutting tool according to one embodiment of the present disclosure.
Fig. 6 shows an example of a target used in the production of a cutting tool according to one embodiment of the present disclosure.
Fig. 7 is a drawing substitute photograph of a dark field image obtained by observing a cross section of a hard carbon film of a conventional cutting tool, using a high angle annular dark field scanning transmission electron microscope image.

DETAILED DESCRIPTION

[Problem to be Solved by the Present Disclosure]

In recent years, the diversity of work materials has advanced, and processing of soft metals such as aluminum alloys, non-ferrous metals such as titanium, magnesium, and copper, organic materials, materials containing hard particles such as graphite, and carbon fiber reinforced plastics (CFRP) has been carried out.
When cutting the above materials using a cutting tool having a hard carbon film, the work material tends to adhere to the cutting edge portion of the tool, causing increased cutting resistance, cutting edge breakages, and a decreased tool life. This is especially likely to occur when dry processing or MQL processing of soft metals. Accordingly, there is a need for a cutting tool that can have a long tool life even when used to cut soft metals.

Therefore, an object of the present disclosure is to provide a cutting tool that can have a long tool life even when used to cut soft metals.

[Advantageous Effect of the Present Disclosure]

According to the present disclosure, it is possible to provide a cutting tool that can have a long tool life even when used to cut soft metals in particular.

[Description of Embodiments]

At first, implementations of the present disclosure are described.

A cutting tool of the present disclosure is according to claim 1.

The cutting tool of the present disclosure can have a long tool life even when used to cut soft metals in particular.

It is preferable that, in the hard carbon film, the area percentage of black regions with an equivalent circle diameter of 10 nm or more is 0.7% or less, wherein
the area percentage of black regions is measured in a high angle annular dark field scanning transmission electron microscope image of a cross section of the hard carbon film.

According to this, since the amount of defects in the hard carbon film is reduced, destruction originating from defects is unlikely to occur. Therefore, the tool life of the cutting tool is further improved.

The hard carbon film preferably has a thickness of 0.1 $\mu$m or more and 3.0 $\mu$m or less at a portion involved in cutting. According to this, exfoliations or breakages of the hard carbon film can be suppressed.

The hard carbon film preferably has a hydrogen content ratio of 5 atom% or less. According to this, the proportion of sp3 hybrid bonds in the hard carbon film is higher, resulting in higher hardness. Furthermore, the oxidation resistance of the hard carbon film is also improved. Therefore, the tool life of the cutting tool is further improved.

It is preferable that the cutting tool comprises an interface layer disposed between the base material and the hard carbon film,

wherein the interface layer contains:

· at least one selected from the group consisting of a material made of one element selected from a first group consisting of Group 4 elements, Group 5 elements, Group 6 elements, Group 13 elements, and Group 14 elements excluding carbon in the Periodic Table, an alloy or first compound containing at least one element selected from the first group, and a solid solution derived from the first compound; or
· one or both of a second compound composed of at least one element selected from the first group and carbon, and a solid solution derived from the second compound, and

the interface layer has a thickness of 0.5 nm or more and less than 10 nm.

According to this, while the base material and the hard carbon film are firmly adhered to each other via the interface layer, which suppresses adhesive wear that causes the coating to exfoliate at the time of deposition falling, the interface layer acts to balance the difference in hardness between the base material and the hard carbon film, in other words, it acts as a buffer, which improves impact resistance as well.

The base material is preferably composed of WC-based cemented carbide or cermet. According to this, the cutting tool is suited for cutting non-ferrous alloys, especially aluminum alloys, copper alloys, magnesium alloys, and others.

The base material is preferably composed of cubic boron nitride. According to this, the cutting tool is suited for cutting non-ferrous alloys, especially aluminum alloys, copper alloys, magnesium alloys, and others.

[Details of Embodiments of the Present Disclosure]

Hereinafter, a specific example of the cutting tool of the present disclosure will be described with reference to drawings. In the drawings of the present disclosure, the same reference signs represent the same portions or equivalent portions. In addition, dimensional relationships such as length, width, thickness, and depth are changed as appropriate for clarity and simplicity in the drawings and do not necessarily represent actual dimensional relationships.

Notations in the form of "A to B" as used herein mean the upper limit and lower limit of the range (that is, A or more and B or less), and when no unit is given in A but only in B, the unit in A is the same as the unit in B.

The present inventors have investigated the reasons why adherence occurs when soft metals are cut using cutting tools having conventional hard carbon films. Since adherence is likely to occur especially in the early stages of cutting, the present inventors have focused on the properties near the surface of the hard carbon film and proceeded with investigations. As a result, it has newly been found that, in conventional hard carbon films, the sp2 component amount in the near-surface region is larger than the sp2 component amount in the region deeper in the thickness direction (the region on the base material side compared to the near-surface region). As used herein, the sp2 component corresponds to the sp2 hybrid bonds in the hard carbon film. Here, the sp2 hybrid bonds correspond to the double bonds (C=C) derived from the graphite component. The sp2 component amount corresponds to the number of carbon atoms constituting the sp2 hybrid bonds. Therefore, cutting tools having conventional hard carbon films have a large amount of graphite component, which tends to cause adherence, near the surface, and for this reason, it is assumed that adherence is likely to occur, especially in the early stages of cutting. Based on the above new finding, the present inventors have made diligent investigations and consequently obtained a cutting tool that can have a long tool life even when used to cut soft metals. Hereinafter, the cutting tool of the present disclosure will be described.

[Embodiment 1: Cutting Tool]

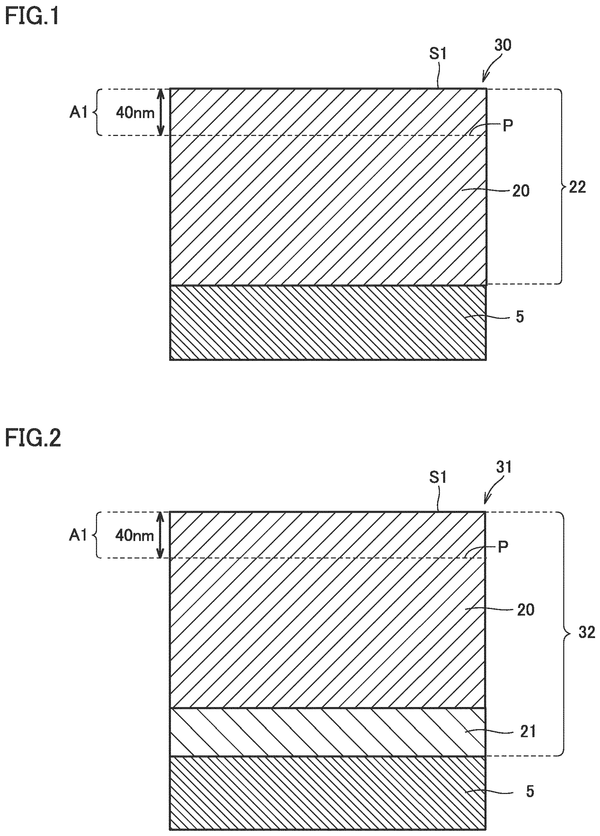

A cutting tool according to one embodiment of the present disclosure (hereinafter, also referred to as "the present embodiment") will be described with reference to Figs. 1 and 2. Fig. 1 is a cross-sectional view of an example of the cutting tool according to the present embodiment. Fig. 2 is a cross-sectional view of another example of the cutting tool according to the present embodiment.

As shown in Fig. 1, a cutting tool 30 of the present embodiment is

a cutting tool comprising a base material 5 and a film 22 arranged on the base material 5, in which
the film 22 includes a hard carbon film 20 on the outermost surface thereof,
the hard carbon film 20 includes a first region A1,
the first region A1 is a region sandwiched between a surface S1 of the hard carbon film 20 and an imaginary plane P at a distance of 40 nm from the surface S1 to the base material 5 side, and
the sp2 component amount C2 and the sp3 component amount C3 in the first region A1 exhibit a relationship of the following formula 1:

$$\{C2/(C2 + C3)\} \times 100 \leq 2.0 \qquad \text{formula 1.}$$

The cutting tool of the present embodiment can have a long tool life even when used to cut soft metals. The reason for this is presumably that the sp2 component (graphite component) ratio near the surface of the hard carbon film is small in the cutting tool of the present embodiment, making it difficult for adherence to occur. Furthermore, the reason is presumably that, since adherence is unlikely to occur, cutting resistance is reduced and the wear resistance of the cutting tool is improved as well.

<Base Material>

As base material 5, metallic or ceramic base materials can be used. Specific examples thereof include base materials made of iron, heat-treated steel, WC-based cemented carbides (for example, WC-based cemented carbides such as WC-Co type cemented carbides, where the cemented carbides can include carbonitrides of Ti, Ta, Nb, and others), cermets (those mainly composed of TiC, TiN, TiCN, and others), stainless steel, nickel, copper, aluminum alloys, titanium alloys, alumina, cubic boron nitride, and silicon carbide.

Among these various base materials, it is preferable to use a base material composed of WC-based cemented carbide, cermet (especially TiCN-based cermet), or cubic boron nitride. These base materials have an excellent balance between hardness and strength at high temperatures, and have excellent characteristics as the base material of cutting tools for the above application. When a WC-based cemented carbide is used as the base material, its construction may contain free carbon and an abnormal layer called the η phase or ε phase.

Furthermore, the base material may have its surface modified. For example, in the case of cemented carbides, a β-free layer may be formed on the surface thereof, or a surface hardening layer may be formed in the case of cermets. The base material exhibits the desired effects even when the surface thereof is modified.

<Film>

The film includes a hard carbon film on the outermost surface thereof. In Fig. 1, film 22 is composed solely of hard carbon film 20, and base material 5 and hard carbon film 20 are in contact with each other, but the cutting tool of the present embodiment is not limited to this. For example, as shown in Fig. 2, in a cutting tool 31 of the present embodiment, a film 32 can comprise, in addition to hard carbon film 20, an interface layer 21 disposed between base material 5 and hard carbon film 20.

In addition to the hard carbon film and the interface layer, the film can comprise, between the base material and the interface layer, a mixed composition layer (not shown in the figure) in which the compositions of these films are mixed, or a gradient composition layer (not shown in the figure) in which the composition varies continuously. Furthermore, in addition to the hard carbon film and the interface layer, the film can comprise an underlying layer (not shown in the figure) between the base material and the interface layer for improving the adhesiveness between them.

The film may be arranged so as to cover the entire surface of the base material, or it may be arranged so as to cover part of it. When the film is arranged so as to cover part of the base material, it is preferably arranged so as to cover at least the surface of a portion of the base material involved in cutting. The portion of the base material involved in cutting as used herein means a region in the base material bounded by its cutting edge ridgeline and a hypothetical plane at a distance of 2 mm from the cutting edge ridgeline to the base material side along the perpendicular line of the tangent line of the cutting edge ridgeline.

The thickness of the entire film is preferably 0.1 $\mu$m or more and 3 $\mu$m or less. When the thickness of the entire film is 0.1 $\mu$m or more, wear resistance is improved. When the thickness of the entire film is 3 $\mu$m or less, an increase in the internal stress accumulated inside the film can be suppressed, and exfoliations or breakages of the film can be suppressed.

The lower limit of the thickness of the film is preferably 0.1 $\mu$m or more, more preferably 0.3 $\mu$m or more, and still more preferably 1.0 $\mu$m or more. The upper limit of the thickness of the film is preferably 3.0 $\mu$m or less, more preferably 2.0 $\mu$m or less, and still more preferably 1.5 $\mu$m or less. The thickness of the film is preferably 0.1 $\mu$m or more and 3.0 $\mu$m or less, more preferably 0.3 $\mu$m or more and 2.0 $\mu$m or less, and still more preferably 1.0 $\mu$m or more and 1.5 $\mu$m or less.

As used herein, the "thickness" is measured by observing a cross section along the normal line to the film surface using a SEM (scanning electron microscope, measurement apparatus: "JSM-6610 series" (TM) manufactured by JEOL Ltd.). Specifically, the observation magnification for the cross section sample is set to 15,000 times, a rectangular measurement field of view of (30 $\mu$m parallel to the base material surface) $\times$ (distance including the entire thickness of the film) is set in the electron microscope image, the thickness width is measured at three locations in the field of view, and the average value thereof is used as the "thickness". The thickness (average thickness) of each layer described below is also measured and calculated in the same manner.

Note that, as far as the applicants performed measurements, even if the measurements were performed multiple times by changing the selected locations in the measurement field of view, there was almost no variation in the measurement results, and it was confirmed that the arbitrary setting of the measurement field of view did not result in arbitrary results as long as the measurements were performed on the same sample.

<Hard Carbon Film>

(Composition)

In the present specification, the term "hard carbon film" means what is commonly referred to by names such as diamond-like carbon (DLC), amorphous carbon, and diamond-like carbon. The hard carbon film contains carbon as its main component, and is structurally classified as amorphous rather than crystalline. It is thought to contain a mixture of single bonds (C-C), as seen in diamond crystal, and double bonds (C=C), as seen in graphite crystal, and depending on the production method, it may contain hydrogen, such as C-H.

The hard carbon film containing carbon as its main component means that the carbon content of the hard carbon film is 95 atom% or more. The carbon content in the hard carbon film can be measured using an energy dispersive X-ray spectrometer (EDS analysis apparatus: "XFlash 6-30" (TM) manufactured by BRUKER). Specifically, the outermost surface of the hard carbon film is irradiated with electron beams, the characteristic X-rays generated by the electron beam irradiation are detected, and spectral diffraction is performed with energy, thereby performing elemental analysis and compositional analysis. The acceleration voltage of the electron beam is set to 15 kV. Elemental analysis and calculation of carbon content from the obtained spectrum are performed using the software "QUANTAX ESPRIT" (TM) accompanying the above analysis apparatus.

As far as the applicants performed measurements, even if the measurement results of the carbon content were calculated multiple times by changing the selected locations in the measurement region, there was almost no variation in the measurement results, and it was confirmed that the arbitrary setting of the measurement region did not result in arbitrary results as long as the measurements were performed on the same sample.

Whether the hard carbon film is amorphous can be confirmed by, for example, X-ray diffraction measurement. A specific confirmation method will be described below.

(A1) The hard carbon film formed on the substrate is subjected to X-ray diffraction measurement (measurement apparatus: "SmartLab" (TM) manufactured by Rigaku Corporation) under the conditions below to obtain an X-ray diffraction pattern.

> X-ray source: Cu-k$\alpha$ radiation
> X-ray output: 45 kV, 200 mA
> Detector: one-dimensional semiconductor detector
> Measurement range of diffraction angle $2\theta$: 15 to 140°
> Scanning speed: 0.2°/min

(A2) When, in the obtained diffraction pattern, there are no peaks originating from graphite or diamond other than the peaks originating from the substrate, and a broad peak is observed, the hard carbon film is determined to be a non-crystalline phase.

(sp2 Component Amount C2 and sp3 Component Amount C3)

In the present embodiment, hard carbon film 20 includes first region A1, the first region A1 is a region sandwiched between surface S1 of the hard carbon film 20 and imaginary plane P at a distance of 40 nm from the surface S1 to base material 5 side, and the sp2 component amount C2 and the sp3 component amount C3 in the first region A1 exhibit a relationship of the following formula 1:

$$\{C2/(C2 + C3)\} \times 100 \leq 2.0 \qquad \text{formula 1}.$$

As used herein, the sp2 component amount C2 corresponds to the number of carbon atoms constituting the sp2 hybrid bonds. Here, the sp2 hybrid bonds correspond to the double bonds (C=C) derived from the graphite component in the hard carbon film. As used herein, the sp3 component amount C3 corresponds to the number of carbon atoms constituting the sp3 hybrid bonds. Here, the sp3 hybrid bonds correspond to the C-C bonds (single bonds) derived from the diamond component or the C-H bonds (single bonds) in the hard carbon film. Accordingly, when the hard carbon film satisfies the above formula 1, the graphite component ratio is reduced in the first region positioned near the surface of the hard carbon film. Therefore, the cutting tool comprising the hard carbon film, even when used to cut soft metals, is unlikely to cause adherence in the early stages of cutting, and can have a long tool life. Furthermore, since adherence is unlikely to occur, cutting resistance is reduced and the wear resistance of the cutting tool is improved as well.

The lower limit of the percentage of C2 with respect to the sum of sp2 component amount C2 and sp3 component amount C3 in the first region $\{C2/(C2 + C3)\} \times 100$ (hereinafter, also referred to as the "sp2 content ratio") is not particularly limited, but it can be set to 0.5 or more, for example. In the first region of the hard carbon film, C2 and C3 preferably exhibit a relationship of the following formula 2:

$$0.5 \leq \{C2/(C2 + C3)\} \times 100 \leq 2.0 \qquad \text{formula 2}.$$

In the first region of the hard carbon film, C2 and C3 preferably exhibit a relationship of the following formula 3, and more preferably exhibit a relationship of the following formula 4:

$$0.5 \leq \{C2/(C2 + C3)\} \times 100 \leq 1.5 \qquad \text{formula 3};$$

and

$$0.5 \leq \{C2/(C2 + C3)\} \times 100 \leq 1.0 \qquad \text{formula 4}.$$

The percentage of sp2 component amount C2 with respect to the sum of sp2 component amount C2 and sp3 component amount C3 ($\{C2/(C2 + C3)\} \times 100$) in the first region of the hard carbon film is measured by XANES (X-ray Absorption Near Edge Structure). A specific measurement method will be described below.

(B1) The X-ray absorption near edge structure (XANES) spectrum of carbon can be measured at synchrotron radiation facilities. As an example, the BL17 Sumitomo Electric beamline at the Kyushu Synchrotron Light Research Center can be utilized. Note that other synchrotron radiation facilities and beamlines can also be used for measurement. An example of measuring the K-edge XANES spectrum of carbon by the electron yield method on the surface of the hard carbon film of the cutting tool is shown, using the BL17 Sumitomo Electric beamline at the Kyushu Synchrotron Light Research Center. The measurement conditions are as follows.

<Measurement Conditions>

Diffraction grating: 400 lines/mm
Incident X-ray energy: 250 to 400 eV
Measured energy steps: $\Delta$0.5 eV (250 to 280 eV, 320 to 400 eV), $\Delta$0.1 eV (280 to 296 eV), $\Delta$0.2 eV (296 to 320 eV)
Integration time: 1 s/step
Measurement method: electron yield method
Detection method: using the Keithley 6485 picoammeter for both I0: M3 mirror current at the most downstream of the beamline, and I1: sample current
Sample fixation: The sample and the sample holder are fixed with carbon tape. The carbon tape is not irradiated with X-rays.
Sample surface treatment: not performed (only alcohol cleaning before measurement)
Measurement chamber vacuum degree: 7E - 8 Pa or less

The XANES spectrum obtained by the above measurement conditions corresponds to the XANES spectrum of the first region surrounded by the surface of the hard carbon film and imaginary plane P at a distance of 40 nm from the surface to the base material side.

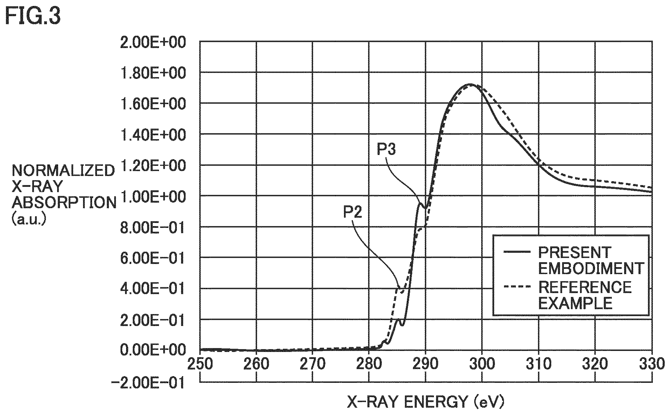

(B2) The bonding state of C can be examined by X-ray absorption spectroscopy (XAS) measurement. In detail, the XAS spectrum near the K-edge of C (hereinafter, also referred to as the XANES spectrum) is measured. An example of the K-edge XANES spectrum of C in the first region of the hard carbon film of the present embodiment is shown in the solid line of Fig. 3. In Fig. 3, the horizontal axis is the X-ray energy (hereinafter, also referred to as the X-ray energy) (eV) and the vertical axis is the normalized X-ray absorption (a.u.). Note that the horizontal axis is calibrated such that the $\pi^*$ peak observed in HOPG (highly oriented pyrolytic graphite) is at 285.5 eV. In order to normalize the X-ray absorption on the vertical axis, software capable of analyzing XANES spectra is used, the sample current intensity for each X-ray energy obtained from the sample is plotted, the X-ray energy range between arbitrary two points in an X-ray energy of 258 eV to 278 eV is subtracted as the background region, and the X-ray energy range between arbitrary two points in an X-ray energy of 340 eV to 400 eV is set as the normalized region. Furthermore, the above two points defining the background region are separated by 10 eV or more at a minimum, and the above two points defining the normalized region are separated by 20 eV or more at a minimum.

As for the software to be used for analysis, software specialized for XANES spectrum analysis can be used, such as REX2000 (manufactured by Rigaku Corporation) and Athena & Artemis [IFEFFIT package] http://cars9.uchicago.edu/ifeffit/Downloads, which is software that is free and available to the general public. Using the above analysis software, the vertical axis intensity is normalized to 1 based on the above-mentioned analysis procedures. Furthermore, peak fitting of the XANES spectrum is carried out and the percentage of sp2 component amount C2 with respect to the sum of sp2 component amount C2 and sp3 component amount C3 ($\{C2/(C2 + C3)\} \times 100$) is calculated. The range of peak fitting is set to the range of 270 eV or more and 346 eV or less. Gaussian is used for the peak function and arctangent for the step function. HOPG (highly-oriented pyrolytic graphite) is used as the standard sample. Note that the percentage of sp2 component amount C2 with respect to the sum of sp2 component amount C2 and sp3 component amount C3 can also be determined based on the above-mentioned analysis procedures by using any software capable of performing the same analysis as the above-mentioned REX2000 and Athena. The peak height h2 of the peak originating from the sp2 hybrid bonds and the peak height h3 of the peak originating from the sp3 hybrid bonds are measured, and the value of $\{h2/(h2 + h3) \times 100\}$ is calculated. This value corresponds to the percentage of sp2 component amount C2 with respect to the sum of sp2 component amount C2 and sp3 component amount C3.

An example of the XANES spectrum of the first region of the hard carbon film of the present embodiment is shown in Fig. 3. In Fig. 3, the solid line is the XANES spectrum of the first region of the hard carbon film of the present embodiment. In Fig. 3, the dashed line is the XANES spectrum of the first region of a hard carbon film formed under the same film formation conditions as the hard carbon film of the present embodiment, but without carrying out polishing of the surface of the hard carbon film (shown as Reference Example in Fig. 3). As shown in Fig. 3, in the XANES spectrum of the first region of the hard carbon film of the present embodiment, the peak originating from the sp2 hybrid bonds, indicated by an arrow P2, and the peak originating from the sp3 hybrid bonds, indicated by an arrow P3, are confirmed at an X-ray energy of 285 eV and at an X-ray energy of 289 eV, respectively.

Note that, as far as the applicants performed measurements, even if the measurements were performed multiple times by changing the selected locations in the measurement region, there was almost no variation in the measurement results, and it was confirmed that the arbitrary setting of the measurement region did not result in arbitrary results as long as the measurements were performed on the same sample.

(Area Percentage of Black Regions)

As for hard carbon film 20, when its cross section is observed using a HADDF-STEM, it is preferable that the area percentage of black regions with an equivalent circle diameter of 10 nm or more (hereinafter, also referred to as the "area percentage of black regions") is 0.7% or less.

The black regions with an equivalent circle diameter of 10 nm or more in the hard carbon film is thought to originate from defects of the film, such as macroparticles and voids present in the film, as well as abnormal growth portions of the film. Accordingly, it is thought that the amount of defects in the hard carbon film is reduced when the area percentage of black regions in the hard carbon film is 0.7% or less.

When cutting soft metals such as aluminum alloys using a cutting tool having a film, the work material is repeatedly deposited on and removed from the film surface. When the deposited work material is removed from the film, stress in the direction of tearing off the film and stress in the shear direction, which is approximately parallel to the film surface, are considered to be exerted on the film. At this time, if defects are present in the film, the defects are considered to be the starting point for destruction of the film, resulting in an advance in damage to the film.

When the area percentage of black regions is 0.7% or less, since the amount of defects in the hard carbon film is reduced, destruction originating from defects is unlikely to occur. Accordingly, the cutting tool can have a long tool life even when used to cut soft metals in particular.

The upper limit of the area percentage of black regions is preferably 0.7% or less, more preferably 0.5% or less, still more preferably 0.3% or less, and still more preferably 0.2% or less. The lower limit of the area percentage of black regions is preferably 0% or more. The lower limit of the area percentage of black regions can be 0.05% or more from the viewpoint of production. The area percentage of black regions is preferably 0% or more and 0.7% or less, preferably 0% or more and 0.5% or less, more preferably 0% or more and 0.3% or less, and still more preferably 0% or more and 0.2% or less.

The area percentage of black regions of the hard carbon film is measured by observation with a high angle annular dark field scanning transmission electron microscope (HADDF-STEM). A specific measurement method will be described below.

(C1) By cutting the cutting tool along the normal direction of the surface, a sample including a cross section of the hard carbon film is fabricated. Ten arbitrary locations in the portion involved in cutting of the cutting tool are set as the cutting positions, and ten samples are fabricated. For the cutting, a focused ion beam apparatus, a cross section polisher apparatus, or the like is used.

(C2) The cross section of each sample is observed by the HADDF-STEM at a magnification of 200,000 times to obtain a high angle annular dark field scanning transmission electron microscope image (hereinafter, also referred to as the "dark field image").

(C3) In the obtained dark field image, the hard carbon film is identified. Energy dispersive X-ray analysis (EDX) associated with the HAADF-STEM is used to carry out mapping analysis of the cross section, enabling identification of the hard carbon film mainly composed of carbon, the interface layer, and the base material.

(C4) Within the hard carbon film region in the dark field image, a rectangular measurement field of view is set. A pair of opposite sides of the rectangle are parallel to the interface of the base material on the hard carbon film side and have a length of 800 nm. The distance between the side on the base material side among the opposite sides and the interface of the base material on the hard carbon film side is 30 nm. The distance between the side on the hard carbon film surface side among the opposite sides and the surface of the hard carbon film is 30 nm.

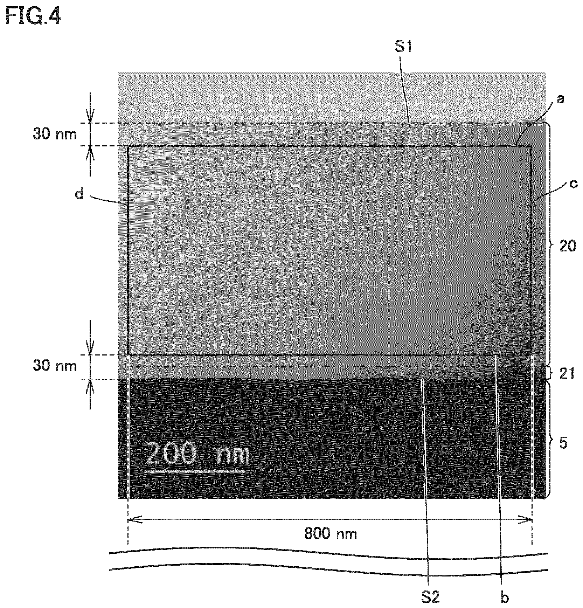

For the above measurement field of view, specific description will be given using Fig. 4. Fig. 4 is a dark field image obtained by observing a cross section of the cutting tool of the present embodiment by a HADDF-STEM at a magnification of 200,000 times. In the dark field image, the region surrounded by a line segment a, a line segment b, a line segment c, and a line segment d corresponds to the rectangular measurement field of view. A pair of opposite sides (line segment a and line segment b) of the rectangle are parallel to an interface S2 of base material 5 on the hard carbon film side and have a length of 800 nm. The distance between the side (line segment b) on the base material side among the opposite sides, and interface S2 of base material 5 on the side of hard carbon film 20 is 30 nm. The distance between the side (line segment a) on the side of a surface S1 of hard carbon film 20 among the opposite sides, and surface S1 of hard carbon film 20 is 30 nm.

When interface S2 of base material 5 on the hard carbon film side has irregularities, interface S2 of base material on the hard carbon film side is set as follows. In the measurement field of view, the portion of the base material with the greatest protrusion toward the hard carbon film side is identified. A line is drawn that passes through this portion and is parallel to the average line of the irregularities on the principal plane of the base material. This line is taken as interface S2 of the base material on the hard carbon film side.

When the surface of hard carbon film 20 has irregularities, surface S1 of the hard carbon film is set as follows. In the measurement field of view, the portion on the surface of the hard carbon film with the greatest depression is identified. A line is drawn that passes through this portion and is parallel to the average line of the irregularities on the hard carbon film surface. This line is taken as surface S1 of the hard carbon film.

The reason for excluding the region in the hard carbon film where the distance from interface S2 on the base material side is within 30 nm and the region in the hard carbon film where the distance from surface S1 is within 30 nm in the setting of the measurement field of view is to exclude the influence of sample adjustment and the influence of the interface layer.

(C5) The dark field image is subjected to image processing using an image analysis software ("WinROOF" (TM) from Mitani Corporation) and is converted to a monochrome image with 256 gradations. At this time, the image that has been converted to a monochrome image with 256 gradations is adjusted so that there is no contrast difference in white regions within the measurement field of view.

(C6) In the above monochrome image, the average density within the above measurement field of view is determined. Using this average density as the threshold value, binarization processing is carried out on the monochrome image.

(C7) The image after the binarization processing is subjected to particle analysis to determine the area of black regions with an equivalent circle diameter of 10 nm or more. The area percentage of black regions with an equivalent circle diameter of 10 nm or more with respect to the entire area of the measurement field of view is calculated.

(C8) For each of the ten samples, the area percentage of black regions is measured. The average value of the area percentages of black regions measured for the ten samples is taken as "the area percentage of black regions of the hard carbon film". Specifically, when the average value of the area percentages of black regions measured for the ten samples is 0.7% or less, it is confirmed that "the area percentage of black regions of the hard carbon film is 0.7% or less".

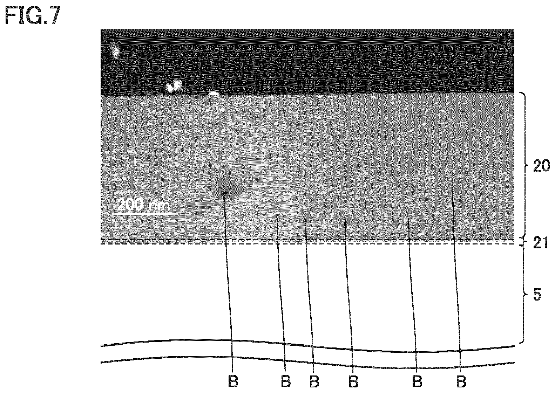

Since there are almost no black regions in the cutting tool of the present embodiment photographed in Fig. 4, almost no black regions are confirmed either in the dark field image of Fig. 4. As a reference example where the presence of black regions can be confirmed, Fig. 7 shows a dark field image obtained by observing a cross section of a hard carbon film of a conventional cutting tool, using a high angle annular dark field scanning transmission electron microscope. In Fig. 7, the black portions indicated by a sign B correspond to the black regions.

As far as the applicants performed measurements, even if the selected locations for the cutting plane or the selected locations in the measurement field of view were changed, there was almost no variation in the measurement results, and it was confirmed that the arbitrary setting of the measurement field of view did not result in arbitrary results as long as the measurements were performed on the same sample.

(Thickness)

Hard carbon film 20 preferably has a thickness of 0.1 $\mu$m or more and 3.0 $\mu$m or less at a portion involved in cutting (hereinafter, also referred to as "thickness of the hard carbon film"). The portion of the hard carbon film involved in cutting as used herein means a region in the hard carbon film bounded by the cutting edge ridgeline of the cutting tool and a hypothetical plane at a distance of 2 mm from the cutting edge ridgeline to the cutting tool side along the perpendicular line of the tangent line of the cutting edge ridgeline. The thickness of the portion of the hard carbon film involved in cutting means the thickness of the hard carbon film in the region of the hard carbon film involved in cutting, starting from its surface in the direction along the normal line of the surface.

When the thickness of the hard carbon film is 0.1 $\mu$m or more, wear resistance is improved. When the thickness of the hard carbon film is 3 $\mu$m or less, an increase in the internal stress accumulated inside the hard carbon film can be suppressed, and exfoliations or breakages of the hard carbon film can be suppressed.

The lower limit of the thickness of the hard carbon film is preferably 0.1 $\mu$m or more, more preferably 0.5 $\mu$m or more, and still more preferably 1 $\mu$m or more. The upper limit of the thickness of the hard carbon film is preferably 3 $\mu$m or less, more preferably 2 $\mu$m or less, and still more preferably 1.5 $\mu$m or less. The thickness of the hard carbon film is preferably 0.1 $\mu$m or more and 3.0 $\mu$m or less, more preferably 0.5 $\mu$m or more and 2 $\mu$m or less, and still more preferably 1 $\mu$m or more and 1.5 $\mu$m or less.

(Hydrogen Content Ratio)

Hard carbon film 20 is basically composed of carbon and inevitable impurities, but may contain hydrogen. This hydrogen is thought to originate from residual hydrogen and moisture in the film forming apparatus that is incorporated into the hard carbon film during film formation.

Hard carbon film 20 preferably has a hydrogen content ratio of 5 atom% or less. According to this, the proportion of sp3 hybrid bonds in the hard carbon film is higher, resulting in higher hardness. Furthermore, the oxidation resistance of the hard carbon film is also improved. The upper limit of the hydrogen content ratio of the hard carbon film is more preferably 4 atom% or less, and still more preferably 2 atom% or less. The lower limit of the hydrogen content ratio of the hard carbon film is preferably 0 atom%, but from the viewpoint of production, it may be 0 atom% or more, 1 atom% or more, or 2 atom% or more. The hydrogen content ratio of the hard carbon film is preferably 0 atom% or more and 5 atom% or less, more preferably 0 atom% or more and 4 atom% or less, and still more preferably 0 atom% or more and 2 atom% or less. The hydrogen content ratio of the hard carbon film can also be 1 atom% or more and 5 atom% or less, 1 atom% or more and 4 atom% or less, 1 atom% or more and 2 atom% or less, 2 atom% or more and 5 atom% or less, or 2 atom% or more and 4 atom% or less.

The hydrogen content ratio of the hard carbon film can be measured using the ERDA (elastic recoil detection analysis, measurement apparatus: "HRBS500" manufactured by Kobe Steel, Ltd.). In this method, hydrogen (H) ions colliding with helium (He) ions injected at a low angle of incidence are recoiled in the forward direction, and the energy of the recoiled hydrogen particles is analyzed to measure the amount of hydrogen.

Note that, as far as the applicants performed measurements, even if the calculations were performed multiple times by changing the measurement location, there was almost no variation in the measurement results, and it was confirmed that the arbitrary setting of the measurement location did not result in arbitrary results as long as the measurements were performed on the same sample.

(Hardness)

Hard carbon film 20 preferably has a hardness of 35 GPa or more and 75 GPa or less. When the hardness of the hard carbon film is 35 GPa or more, wear resistance is improved. When the hardness of the hard carbon film is 75 GPa or less, breakage resistance is improved. The lower limit of the hardness of the hard carbon film is preferably 35 GPa or more, more preferably 45 GPa or more, and still more preferably 55 GPa or more. The upper limit of the hardness of the hard carbon film is preferably 75 GPa or less, and still more preferably 73 GPa or less. The hardness of the hard carbon film is preferably 35 GPa or more and 75 GPa or less, more preferably 45 GPa or more and 73 GPa or less, and still more preferably 55 GPa or more and 73 GPa or less.

The hardness of the hard carbon film can be measured by the nanoindenter method (measurement apparatus: "Nano Indenter XP" (TM) manufactured by MTS). Specifically, the hardness is measured at three locations on the surface of the hard carbon film, and their average value is used as the "hardness".

Note that, as far as the applicants performed measurements, even if the calculations were performed multiple times by changing the measurement location, there was almost no variation in the measurement results, and it was confirmed that the arbitrary setting of the measurement location did not result in arbitrary results as long as the measurements were performed on the same sample.

<Interface Layer>

As shown in Fig. 2, cutting tool 31 of the present embodiment can comprise interface layer 21 disposed between base material 5 and hard carbon film 20. According to this, the base material and the hard carbon film are firmly adhered to each other via the interface layer.

(Composition)

The composition of interface layer 21 can be as in (K1) or (K2) below.

(K1) Containing at least one selected from the group consisting of a material made of one element selected from a first group consisting of Group 4 elements, Group 5 elements, Group 6 elements, Group 13 elements, and Group 14 elements excluding carbon in the Periodic Table, an alloy or first compound containing at least one element selected from the first group, and a solid solution derived from the first compound.

(K2) Containing one or both of a second compound composed of at least one element selected from the above first group and carbon, and a solid solution derived from the second compound.

That is, the interface layer can be in any of the following forms (k1) to (k4).

(k1) Composed of at least one selected from the group consisting of a material made of one element selected from the first group, an alloy or first compound containing at least one element selected from the first group, and a solid solution derived from the first compound.

(k2) Containing at least one selected from the group consisting of a material made of one element selected from the first group, an alloy or first compound containing at least one element selected from the first group, and a solid solution derived from the first compound.

(k3) Composed of one or both of a second compound composed of at least one element selected from the first group and carbon, and a solid solution derived from the second compound.

(k4) Containing one or both of a second compound composed of at least one element selected from the first group and carbon, and a solid solution derived from the second compound.

Here, Group 4 elements in the Periodic Table include, for example, titanium (Ti), zirconium (Zr), and hafnium (Hf).

Group 5 elements include, for example, vanadium (V), niobium (Nb), and tantalum (Ta). Group 6 elements include, for example, chromium (Cr), molybdenum (Mo), and tungsten (W). Group 13 elements include, for example, boron (B), aluminum (Al), gallium (Ga), and indium (In). Group 14 elements excluding carbon include, for example, silicon (Si), germanium (Ge), and tin (Sn). Hereinafter, elements included in Group 4 elements, Group 5 elements, Group 6 elements, Group 13 elements, and Group 14 elements excluding carbon are also referred to as the "first elements".

Examples of the alloy containing the first elements include Ti-Zr, Ti-Hf, Ti-V, Ti-Nb, Ti-Ta, Ti-Cr, and Ti-Mo. Examples of the intermetallic compound containing the first elements include $TiCr_2$ and $Ti_3Al$.

Examples of the first compound containing the first elements include titanium boride ($TiB_2$), zirconium boride ($ZrB_2$), hafnium boride ($HfB_2$), vanadium boride ($VB_2$), niobium boride ($NbB_2$), tantalum boride ($TaB_2$), chromium boride (CrB), molybdenum boride (MoB), tungsten boride (WB), and aluminum boride ($AlB_2$).

The above solid solution derived from the first compound means a state in which two or more of these first compounds are dissolved within the crystal structure of each other, meaning an interstitial solid solution or a substitutional solid solution.

Examples of the second compound composed of the first elements and carbon include titanium carbide (TiC), zirconium carbide (ZrC), hafnium carbide (HfC), vanadium carbide (VC), niobium carbide (NbC), tantalum carbide (TaC), chromium carbide ($Cr_3C_2$), molybdenum carbide (MoC), tungsten carbide (WC), and silicon carbide (SiC).

The above solid solution derived from the second compound means a state in which two or more of these second compounds are dissolved within the crystal structure of each other, meaning an interstitial solid solution or a substitutional solid solution.

The total content ratio of the one a material made of one element selected from the first group, the alloy or first compound containing at least one selected from the first group, and the solid solution derived from the first compound in the interface layer (hereinafter, also referred to as the "content ratio of the first compound and the like") is preferably 70% or more by volume and 100% or less by volume, more preferably 80% or more by volume and 100% or less by volume, still more preferably 90% or more by volume and 100% or less by volume, and most preferably 100% by volume.

The total content ratio of the second compound and the solid solution derived from the second compound in the interface layer (hereinafter, also referred to as the "content ratio of the second compound and the like") is preferably 70% or more by volume and 100% or less by volume, more preferably 80% or more by volume and 100% or less by volume, still more preferably 90% or more by volume and 100% or less by volume, and most preferably 100% by volume.

The composition of the interface layer, the content ratio of the first compound and the like, and the content ratio of the second compound and the like can be measured by the transmission electron microscopy-energy dispersive X-ray spectrometry (TEM-EDX) method. Specifically, the cutting tool is cut with a FIB (focused ion beam) apparatus to expose the interface layer, and while observing the cross section with a TEM, the composition of the elements constituting the interface layer, the content ratio of the first compound and the like, and the content ratio of the second compound and the like are measured.

As far as the applicants performed measurements, even if the measurement results were calculated multiple times by changing the selected locations in the measurement field of view, there was almost no variation in the measurement results, and it was confirmed that the arbitrary setting of the measurement field of view did not result in arbitrary results as long as the measurements were performed on the same sample.

(Thickness)

Interface layer 21 preferably has a thickness of 0.1 nm or more and less than 10 nm. When the thickness of the interface layer is in this range, the effect of enhancing the adhesiveness between the base material and the hard carbon film is improved. The thickness of the interface layer is more preferably 0.6 nm or more and 8 nm or less, and still more preferably 1 nm or more and 5 nm or less.

<Other Layer>

The cutting tool of the present embodiment preferably comprises, between the interface layer and the hard carbon film, a mixed composition layer in which the compositions of these films are mixed, or a gradient composition layer in which the composition varies continuously. According to this, the adhesive force between the base material and the hard carbon film is further improved.

It is not always possible to clearly distinguish between the mixed layer and the gradient composition layer. When switching production conditions from the film formation of the interface layer to the film formation of the hard carbon film, there usually occurs a slight mixing of the compositions of the interface layer and the hard carbon film, resulting in formation of the mixed composition layer or gradient composition layer. Although it is difficult to directly confirm the above, their presence can be sufficiently inferred from the results of XPS (X-ray photo-electronic spectroscopy) or AES (Auger electron spectroscopy).

<Applications of Cutting Tool>

Since the cutting tool of the present embodiment is excellent in wear resistance and adherence resistance, it is particularly suited for processing of aluminum and alloys thereof. It is also suited for processing of non-ferrous materials such as titanium, magnesium, and copper. Furthermore, it is also suited for cutting of materials containing hard particles such as graphite, organic materials, and other materials, as well as for processing of printed circuit boards and simultaneous cutting of ferrous materials and aluminum. In addition, the hard carbon film of the cutting tool of the present embodiment has very high hardness, and therefore can be used for processing of not only non-ferrous materials, but also steels such as stainless steels, casting products, and other materials.

<Type of Cutting Tool>

The cutting tool of the present embodiment can be, for example, a drill, an end mill, an indexable tip for end milling, an indexable tip for milling, an indexable tip for turning, a metal saw, a gear cutting tool, a reamer, and a tap.

[Embodiment 2: Method for Manufacturing Cutting Tool]

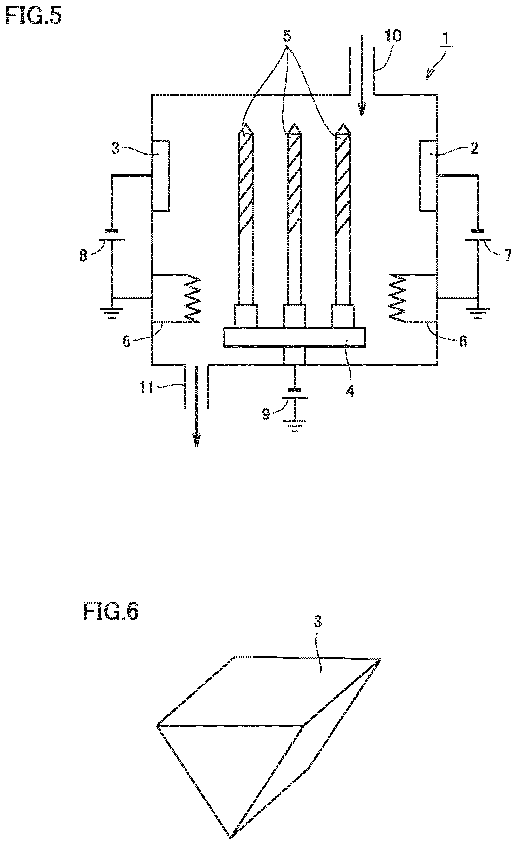

The cutting tool of the present disclosure can be fabricated by, for example, forming a film including a hard carbon film on a base material using a film forming apparatus 1 shown in Fig. 5. An example of the method for manufacturing the cutting tool of the present disclosure will be described below.

(Preparation of Base Material)

Base material 5 is prepared. The type of the base material used can be any of those described in Embodiment 1. For example, the base material is preferably composed of WC-based cemented carbide, cermet, or cubic boron nitride.

Base material 5 is mounted on a base material holder 4 in film forming apparatus 1. Base material holder 4 is rotated between targets around the central point of targets 2 and 3.

While base material 5 is heated to 200°C using a base material heating heater 6, the degree of vacuum in film forming apparatus 1 is set to an atmosphere of $5 \times 10^{-4}$ Pa. Subsequently, the set temperature of base material heating heater 6 is lowered and the base material temperature is brought to 100°C, and then argon plasma cleaning is carried out on the surface of the base material by applying a voltage of -1000 V to base material holder 4 with a film forming bias power supply 9 while introducing argon gas and maintaining an atmosphere of $2 \times 10^{-1}$ Pa. Thereafter, the argon gas is exhausted. In film forming apparatus 1, the gas is supplied through a gas supply port 10, and the gas is discharged through an exhaust port 11.

Next, target 2 composed of a Group 4 element, Group 5 element, or Group 6 element in the Periodic Table is disposed in film forming apparatus 1.

While evaporating and ionizing target 2, a voltage of -600 V is applied to base material holder 4 with bias power supply 9 to carry out metal ion bombardment treatment. As a result, the surface of the base material is etched, improving the adhesiveness of the interface layer and hard carbon film that will be formed later.

Note that the formation of the interface layer and formation of the hard carbon film, which will be mentioned later, may be carried out without carrying out the metal ion bombardment treatment on the base material.

(Formation of Interface Layer)

Next, target 2 composed of one element selected from Group 4 elements, Group 5 elements, Group 6 elements, Group 13 elements, and Group 14 elements excluding carbon in the Periodic Table is disposed in film forming apparatus 1. The target 2 is evaporated and ionized by vacuum arc discharge while introducing or not introducing hydrocarbon gas, and a voltage of -100 V to -800 V is applied to base material holder 4 with bias power supply 9 to form the interface layer on the base material. Thereafter, the hydrocarbon gas is exhausted.

Note that the formation of the hard carbon film, which will be mentioned later, may be carried out without forming the interface layer on the base material.

(Formation of Hard Carbon Film)

Next, target 3 composed of glassy carbon is disposed in film forming apparatus 1. While introducing argon gas at a flow rate of 5 to 25 cc/min, target 3 is evaporated and ionized by vacuum arc discharge (cathode current 100 to 120 A), and a voltage of - 50 to 150 V is applied to base material holder 4 with bias power supply 9 to form the hard carbon film on the interface layer, thereby obtaining the cutting tool. Hydrocarbon gas may be introduced along with argon gas. The temperature of base material heating heater 6 during the film formation is set to 180°C.

As the glassy carbon, those commercially available can be used. Glassy carbon is a highly pure carbonaceous material and is free from contamination by metallic elements compared to a sintered material of carbon (such as sintered graphite) used in conventional cathodes. In particular, glassy carbon manufactured by Hitachi Chemical Co., Ltd. does not contain aluminum (Al) and is therefore particularly suitable for cutting of aluminum alloys. Also, when glassy carbon is used, generation of macroparticles in the hard carbon film can be suppressed and a smooth hard carbon film can be obtained, improving cutting performance.

The shape of the target used is generally cylindrical, disk-shaped, or rectangular. However, as a result of diligent investigations, the present inventors have newly found that a triangular prism shape, as shown in Fig. 6, is suitable from the viewpoint of improving the film quality of the hard carbon film. To the target, a high current needs to be applied, and the use of a V-shaped electrode and adhesion between the side of the target and the electrode enables a stable power supply to the target. Furthermore, because the target and the electrode adhere to each other, the cooling effect can also be enhanced. Efficient cooling of the target lowers electrical resistance and facilitates arc spot migration. As a result, occurrence of defects in the hard carbon film is suppressed and the film quality of the hard carbon film is improved.

From the viewpoint of improving the purity of the hard carbon film, film formation in a vacuum without introducing Ar gas is preferred. However, as a result of diligent investigations, the present inventors have newly found that arc discharge is more stable and film quality is improved when Ar gas is supplied at a flow rate of 15 cc/min rather than in a vacuum.

(Polishing of Hard Carbon Film)

Next, the surface of the hard carbon film formed as described above is polished. The region near the surface of the hard carbon film obtained as described above has a larger sp2 content ratio compared to the region deeper in the thickness direction than that. Therefore, by removing the region near the surface by polishing, the region with a small sp2 content ratio can be exposed on the outermost surface. In the hard carbon film after the surface polishing, the sp2 component amount C2 and the sp3 component amount C3 in the first region exhibit a relationship of the following formula 1:

$$\{C2/(C2 + C3)\} \times 100 \leq 2.0 \qquad \text{formula 1.}$$

The polishing method is preferably mechanical polishing with a wet medium. The polishing amount is preferably 40 nm or more. The surface of the hard carbon film obtained by the method for forming the hard carbon film described above is smooth. Therefore, by the above-described polishing method and polishing amount, not only can the region with a large sp2 content ratio be removed, but also the surface after removal becomes smooth, which improves adherence resistance.

Note that conventional hard carbon films have a large sp2 content ratio throughout the entire hard carbon film. Therefore, even when the surface of conventional hard carbon films is polished, the sp2 component amount C2 and the sp3 component amount C3 in the region near the newly exposed surface do not satisfy the relationship of formula 1 described above.

Conventional hard carbon films have more black regions (droplets and others) than the hard carbon films obtained by the method for forming the hard carbon film of the present embodiment described above. Therefore, even when the surface of conventional hard carbon films is polished, adherence is likely to occur due to the influence of black regions.

Conventional hard carbon films have a large surface roughness. Therefore, when the surface is smoothed by polishing in order to improve adherence resistance, the polishing amount becomes large, cracks and failures occur in the film at the cutting edge ridgeline portion, and the tool life tends to be shortened.

From the above, even when the surface of conventional hard carbon films is polished, it is not possible to obtain a hard carbon film in which the sp2 component amount C2 and the sp3 component amount C3 in the first region exhibit the relationship of formula 1 described above.

[Supplementary Note 1] In the cutting tool of the present embodiment, the base material and the hard carbon film can be in contact with each other.

[Supplementary Note 2] The cutting tool of the present embodiment preferably comprises an interface layer disposed between the base material and the hard carbon film,

wherein the interface layer contains:

at least one selected from the group consisting of a material made of one element selected from a first group consisting of Group 4 elements, Group 5 elements, Group 6 elements, Group 13 elements, and Group 14 elements excluding carbon in the Periodic Table, an alloy or first compound containing at least one element selected from the first group, and a solid solution derived from the first compound; or

one or both of a second compound composed of at least one element selected from the first group and carbon, and a solid solution derived from the second compound, and

the interface layer has a thickness of 0.5 nm or more and less than 10 nm. Examples

The present embodiments will be described even further specifically by way of Examples. However, the present embodiments shall not be limited by these Examples.

[Fabrication of Cutting Tool]

<<Sample 1 to Sample 3, Samples 8 to 23, Sample 1-1, and Sample 1-3>>

In Sample 1 to Sample 3, Samples 8 to 23, Sample 1-1, and Sample 1-3, cutting tools were fabricated by using glassy carbon as a raw material and forming the hard carbon film on the base material using the cathodic arc ion plating method (referred to as "Arc method" in Table 1).

(Preparation of Base Material)

A $\varphi$6 mm drill made of WC (particle size: 1 $\mu$m) based cemented carbide (model number: MDW0600NHGS5) was prepared as the base material. This base material contains 8% by mass of Co as the binder.
The base material was mounted inside film forming apparatus 1 shown in Fig. 5, and while heating the base material to 200°C using base material heating heater 6, the degree of vacuum in film forming apparatus 1 was set to an atmosphere of $5 \times 10^{-4}$ Pa. Subsequently, the set temperature of base material heating heater 6 was lowered and the base material temperature was brought to 100°C, and then argon plasma cleaning was carried out on the surface of the base material by applying a voltage of -1000 V to base material holder 4 with film forming bias power supply 9 while introducing argon gas and maintaining an atmosphere of $2 \times 10^{-1}$ Pa. Thereafter, the argon gas was exhausted.

(Formation of Hard Carbon Film)

Next, while introducing argon gas into film forming apparatus 1 at a flow rate described in the "Argon gas flow rate" column of Table 1, a triangular prism-shaped target made of glassy carbon ("Glass-like Carbon" manufactured by Hitachi Chemical Co., Ltd.) was evaporated and ionized by vacuum arc discharge (the cathode current is described in the "Cathode current (A)" column of Table 1), and a voltage described in the "Bias voltage (V)" column under "Film formation conditions of hard carbon film" in Table 1 was applied to base material holder 4 with bias power supply 9 to form the hard carbon film on the base material. The temperature of base material heating heater 6 during the film formation of the hard carbon film was set to 180°C.

(Polishing of Hard Carbon Film)

Next, the surface of the hard carbon film formed as described above was polished, thereby obtaining a cutting tool. The polishing method was mechanical polishing with a wet medium. The polishing amount is as described in the "Polishing amount" column of Table 1. The thickness of the hard carbon film for each sample at a portion involved in cutting after the polishing is as shown in the "Thickness ($\mu$m)" column under "Hard carbon film" in Table 2.

<<Sample 4 to Sample 7>>

In Sample 4 to Sample 7, cutting tools were fabricated by forming the interface layer and the hard carbon film on the base material in this order using the cathodic arc ion plating method.

<Sample 4>

(Preparation of Base Material)

The base material was prepared by the same method as in Sample 1.

(Formation of Interface Layer)

Next, while introducing hydrocarbon gas into film forming apparatus 1 at a flow rate of 15 cc/min, a triangular prism-shaped target made of chromium (Cr) was evaporated and ionized by vacuum arc discharge (cathode current 80 A), and a voltage of -100 V was applied to base material holder 4 with bias power supply 9 to form the interface layer composed of chromium carbide (CrC) with a thickness of 5 nm on the base material. Thereafter, the hydrocarbon gas was exhausted.

(Formation of Hard Carbon Film)

Next, the hard carbon film was formed on the interface layer. The film formation conditions of the hard carbon film are as shown in Table 1. The temperature of base material heating heater 6 during the film formation of the hard carbon film was set to 180°C.

(Polishing of Hard Carbon Film)

Next, the surface of the hard carbon film formed as described above was polished by the same method as for Sample 1, thereby obtaining a cutting tool. The thickness of the hard carbon film at a portion involved in cutting after the polishing is as shown in the "Thickness ($\mu$m)" column under "Hard carbon film" in Table 2.

<Sample 5>

(Preparation of Base Material)

The base material was prepared by the same method as in Sample 1.

(Formation of Interface Layer)

Next, without introducing gas into film forming apparatus 1, a target made of chromium (Cr) was evaporated and ionized by vacuum arc discharge (cathode current 80 A), and a voltage of -800 V was applied to base material holder 4 with bias power supply 9 to form the interface layer composed of chromium (Cr) with a thickness of 5 nm on the base material.

(Formation of Hard Carbon Film)

Next, the hard carbon film was formed on the interface layer. The film formation conditions of the hard carbon film are as shown in Table 1. The temperature of base material heating heater 6 during the film formation of the hard carbon film was set to 180°C.

(Polishing of Hard Carbon Film)

Next, the surface of the hard carbon film formed as described above was polished by the same method as for Sample 1, thereby obtaining a cutting tool. The thickness of the hard carbon film at a portion involved in cutting after the polishing is as shown in the "Thickness ($\mu$m)" column under "Hard carbon film" in Table 2.

<Sample 6>

(Preparation of Base Material)

The base material was prepared by the same method as in Sample 1.

(Formation of Interface Layer)

Next, while introducing hydrocarbon gas into film forming apparatus 1 at a flow rate of 15 cc/min, a triangular prism-shaped target made of titanium (Ti) was evaporated and ionized by vacuum arc discharge (cathode current 80 A), and a voltage of -100 V was applied to base material holder 4 with bias power supply 9 to form the interface layer composed of titanium carbide (TiC) with a thickness of 5 nm on the base material. Thereafter, the hydrocarbon gas was exhausted.

(Formation of Hard Carbon Film)

Next, the hard carbon film was formed on the interface layer. The film formation conditions of the hard carbon film are as shown in Table 1. The temperature of base material heating heater 6 during the film formation of the hard carbon film was set to 180°C.

(Polishing of Hard Carbon Film)

Next, the surface of the hard carbon film formed as described above was polished by the same method as for Sample 1, thereby obtaining a cutting tool. The thickness of the hard carbon film at a portion involved in cutting after the polishing is as shown in the "Thickness ($\mu$m)" column under "Hard carbon film" in Table 2.

<Sample 7>

(Preparation of Base Material)

The base material was prepared by the same method as in Sample 1.

(Formation of Interface Layer)

Next, without introducing gas into film forming apparatus 1, a target made of titanium (Ti) was evaporated and ionized by vacuum arc discharge (cathode current 80 A), and a voltage of -100 V was applied to base material holder 4 with bias power supply 9 to form the interface layer composed of titanium (Ti) with a thickness of 5 nm on the base material.

(Formation of Hard Carbon Film)

Next, the hard carbon film was formed on the interface layer. The film formation conditions of the hard carbon film are as shown in Table 1. The temperature of base material heating heater 6 during the film formation of the hard carbon film was set to 180°C.

(Polishing of Hard Carbon Film)

Next, the surface of the hard carbon film formed as described above was polished by the same method as for Sample 1, thereby obtaining a cutting tool. The thickness of the hard carbon film at a portion involved in cutting after the polishing is as shown in the "Thickness ($\mu$m)" column under "Hard carbon film" in Table 2.

<<Sample 1-2>>

In Sample 1-2, a cutting tool was fabricated by forming the hard carbon film with a thickness of 0.5 $\mu$m on the same base material as Sample 1, using a plasma CVD method with methane gas as the raw material.

[Table 1]

Table 1

| Sample No. | Film formation method | Target | Formation conditions of hard carbon film | | | | Polishing amount |
|---|---|---|---|---|---|---|---|
| | | | Argon gas flow rate (cc/min) | Hydrocarbon gas flow rate (cc/min) | Cathode current (A) | Bias voltage (V) | nm |
| 1 | Arc method | Glassy carbon | 15 | Absent | 120 | -100V | 40 |
| 2 | Arc method | Glassy carbon | 15 | Absent | 120 | -100V | 40 |
| 3 | Arc method | Glassy carbon | 15 | Absent | 100 | -100V | 20 |
| 4 | Arc method | Glassy carbon | 15 | 5 | 120 | -50V | 40 |

(continued)

| Sample No. | Film formation method | Target | Formation conditions of hard carbon film | | | | Polishing amount |
|---|---|---|---|---|---|---|---|
| | | | Argon gas flow rate (cc/min) | Hydrocarbon gas flow rate (cc/min) | Cathode current (A) | Bias voltage (V) | nm |
| 5 | Arc method | Glassy carbon | 15 | 20 | 120 | -50V | 40 |
| 6 | Arc method | Glassy carbon | 15 | 5 | 120 | -150V | 40 |
| 7 | Arc method | Glassy carbon | 15 | Absent | 120 | -100V | 40 |
| 8 | Arc method | Glassy carbon | 15 | Absent | 100 | -100V | 10 |
| 9 | Arc method | Glassy carbon | 15 | Absent | 100 | -100V | 25 |
| 10 | Arc method | Glassy carbon | 15 | Absent | 100 | -100V | 40 |
| 11 | Arc method | Glassy carbon | 15 | Absent | 100 | -100V | 40 |
| 12 | Arc method | Glassy carbon | 15 | Absent | 100 | -100V | 40 |
| 13 | Arc method | Glassy carbon | 15 | Absent | 100 | -100V | 40 |
| 14 | Arc method | Glassy carbon | 15 | Absent | 120 | -100V | 40 |
| 15 | Arc method | Glassy carbon | 15 | Absent | 120 | -100V | 40 |
| 16 | Arc method | Glassy carbon | 15 | Absent | 120 | -100V | 40 |
| 17 | Arc method | Glassy carbon | 15 | Absent | 120 | -100V | 40 |
| 18 | Arc method | Glassy carbon | 15 | 20 | 100 | -50V | 40 |
| 19 | Arc method | Glassy carbon | 15 | 25 | 100 | -50V | 40 |
| 20 | Arc method | Glassy carbon | 15 | 5 | 120 | -50V | 40 |
| 21 | Arc method | Glassy carbon | 15 | 20 | 120 | -50V | 40 |
| 22 | Arc method | Glassy carbon | 15 | 5 | 120 | -150V | 40 |
| 23 | Arc method | Glassy carbon | 15 | Absent | 120 | -100V | 40 |
| 1-1 | Arc method | Glassy carbon | 15 | Absent | 180 | -100V | 20 |
| 1-2 | CVD method | (Methane gas) | - | - | - | - | 40 |
| 1-3 | Arc method | Glassy carbon | 15 | Absent | 120 | -100V | 20 |

[Evaluation]

(Confirmation of Composition and Crystallinity)

The carbon content in the hard carbon film of each sample was measured. A specific measurement method is described in Embodiment 1, and thus the description therefor will not be repeated.

In all samples, the carbon content in the hard carbon film was 95 atom% or more. Therefore, the hard carbon film of all samples was confirmed to contain carbon as the main component.

The crystallinity of the hard carbon film of each sample was measured. A specific measurement method is described in Embodiment 1, and thus the description therefor will not be repeated.

In all samples, the hard carbon film was confirmed to be amorphous.

(Measurement of $\{C2/(C2 + C3)\} \times 100$)

For the hard carbon film of each sample, the percentage of sp2 component amount C2 with respect to the sum of sp2 component amount C2 and sp3 component amount C3 ($\{C2/(C2 + C3)\} \times 100$) in the first region was measured. A specific measurement method is described in Embodiment 1, and thus the description therefor will not be repeated. The results are shown in the "$\{C2/(C2 + C3)\} \times 100$ (%)" column of Table 2.

(Measurement of Area Percentage of Black Regions)

The area percentage of black regions was measured for the hard carbon film of each sample. A specific measurement method is described in Embodiment 1, and thus the description therefor will not be repeated. The results are shown in the "Area percentage of black regions (%)" column of Table 2.

(Measurement of Hydrogen Content Ratio)

The hydrogen content ratio was measured for the hard carbon film of each sample. A specific measurement method is described in Embodiment 1, and thus the description therefor will not be repeated. The results are shown in the "Hydrogen content ratio (atom%)" column of Table 2.

(Measurement of Hardness)

The hardness was measured for the hard carbon film of each sample. A specific measurement method is described in Embodiment 1, and thus the description therefor will not be repeated. The results are shown in the "Hardness (GPa)" column of Table 2.

(Cutting Test)

Using the cutting tool of each sample, drilling was carried out under the following cutting conditions. The following cutting conditions correspond to MQL processing of soft metals.

Work material: ADC12 (Al-Si-Cu alloy)
Cutting speed: 200 m/min
Feed speed: 0.20 mm/rev
Hole depth: 12 mm (blind hole)
Cutting fluid: water MQL (Unicut Jinen MW-A)

The number of holes drilled until the tip of the drill was worn out, the adherence of the aluminum alloy occurred, and then breakages (500 $\mu$m or more) occurred was measured. The larger the number of drilled holes, the better the wear resistance and the longer the tool life. The results are shown in the "Number of drilled holes" column under "Cutting test" in Table 2.

[Table 2]

Table 2

| Sample No. | Interface layer | Hard carbon film | | | | | Cutting test |
| --- | --- | --- | --- | --- | --- | --- | --- |
| | Type: thickness | {C2/(C2+-C3)}×100 (%) | Area percentage of black regions (%) | Thickness ($\mu$m) | Hydrogen content ratio (atom%) | Hardness (GPa) | Number of drilled holes |
| 1 | Absent | 0.5 | 0.7 | 0.4 | 0.1 | 74 | 4663 |
| 2 | Absent | 0.5 | 0.5 | 1.5 | 0.4 | 66 | 4550 |
| 3 | Absent | 2.0 | 0.2 | 2.9 | 0.2 | 70 | 3010 |
| 4 | CrC:5nm | 0.5 | 0.3 | 0.6 | 1.1 | 54 | 2426 |
| 5 | Cr:5nm | 0.6 | 0.1 | 0.4 | 5.0 | 51 | 2597 |
| 6 | TiC:5nm | 0.5 | 0.1 | 0.6 | 0.6 | 55 | 2822 |
| 7 | Ti:5nm | 0.4 | 0.5 | 0.9 | 0.2 | 72 | 3920 |
| 8 | Absent | 1.5 | 0.1 | 2.9 | 0.2 | 69 | 4026 |

(continued)

| Sample No. | Interface layer | Hard carbon film | | | | | Cutting test |
|---|---|---|---|---|---|---|---|
| | Type: thickness | {C2/(C2+C3)}×100 (%) | Area percentage of black regions (%) | Thickness (μm) | Hydrogen content ratio (atom%) | Hardness (GPa) | Number of drilled holes |
| 9 | Absent | 1.0 | 0.1 | 2.9 | 0.2 | 70 | 4254 |
| 10 | Absent | 0.5 | 0.5 | 0.4 | 0.1 | 72 | 4810 |
| 11 | Absent | 0.5 | 0.3 | 0.4 | 0.1 | 72 | 4918 |
| 12 | Absent | 0.5 | 0.2 | 0.4 | 0.1 | 71 | 5340 |
| 13 | Absent | 0.5 | 0 | 0.4 | 0.1 | 73 | 6320 |
| 14 | Absent | 0.5 | 0.6 | 0.1 | 0.1 | 71 | 3972 |
| 15 | Absent | 0.5 | 0.6 | 3.0 | 0.1 | 73 | 5345 |
| 16 | Absent | 0.5 | 0.7 | 0.05 | 0.1 | 73 | 3281 |
| 17 | Absent | 0.5 | 0.7 | 3.5 | 0.1 | 71 | 2227 |
| 18 | Absent | 0.6 | 0.2 | 0.4 | 5.0 | 50 | 3012 |
| 19 | Absent | 0.6 | 0.2 | 0.4 | 6.0 | 46 | 2830 |
| 20 | Absent | 0.5 | 0.3 | 0.6 | 1.1 | 54 | 2333 |
| 21 | Absent | 0.6 | 0.1 | 0.4 | 5.0 | 51 | 2550 |
| 22 | Absent | 0.5 | 0.1 | 0.6 | 0.6 | 55 | 2816 |
| 23 | Absent | 0.4 | 0.5 | 0.9 | 0.2 | 72 | 3839 |
| 1-1 | Absent | 2.5 | 1.2 | 0.5 | 0.2 | 71 | 1215 |
| 1-2 | Absent | 3.5 | 0.3 | 0.5 | 23 | 23 | 450 |
| 1-3 | Absent | 2.5 | 0.2 | 2.9 | 0.2 | 74 | 325 |

<Discussion>

The cutting tools of Sample 1 to Sample 23 correspond to Examples. The cutting tools of Sample 1-1 to Sample 1-3 correspond to Comparative Examples.

It was confirmed that Sample 1 to Sample 23 (Examples) had a larger number of drilled holes, and a longer tool life compared to Sample 1-1 to Sample 1-3 (Comparative Examples).

Sample 1 to Sample 23 (Examples) have a {C2/(C2 + C3)} ×100 of 2.0 or less, and adherence is unlikely to occur in the early stages of cutting. Therefore, abnormal damage due to adhesive wear is unlikely to occur, and cutting resistance is low as well, which is presumed to result in a long tool life. In the present Examples, it was confirmed that the cutting tool of the present embodiment has a long tool life even in MQL processing of soft metals, where adherence is likely to occur during processing. Accordingly, the cutting tool of the present embodiment is presumed to have a similarly long tool life even in dry processing of soft metals.

Since Sample 1-1 to Sample 1-3 (Comparative Examples) have a {C2/(C2 + C3)} × 100 of 2.5 or more, adherence is likely to occur in the early stages of cutting, which is presumed to result in a short tool life.

While the above description of the embodiments and Examples of the present disclosure has been given, it has been planned from the outset to combine the configuration of each of the above-mentioned embodiments and Examples as appropriate, or to modify them in various ways.

The embodiments and Examples disclosed here should be considered merely illustrative and not restrictive in all respects. The scope of the present invention is presented by the claims rather than the embodiments and Examples given above.

REFERENCE SIGNS LIST

1 film forming apparatus; 2, 3 target; 4 base material holder; 5 base material; 6 base material heating heater; 7, 8 power supply; 9 film forming bias power supply; 10 gas supply port; 11 exhaust port; 20 hard carbon film; 21 interface layer; 22, 32 film; 30, 31 cutting tool; a, b, c, d line segment; P imaginary plane; S1 surface of hard carbon film; S2 interface of base material on hard carbon film side; B black region

**Claims**

1. A cutting tool comprising a base material and a film arranged on the base material, wherein

   the film includes a hard carbon film on an outermost surface thereof, the hard carbon film being diamond-like carbon or amorphous carbon,
   the hard carbon film includes a first region,
   the first region is a region sandwiched between a surface of the hard carbon film and an imaginary plane P at a distance of 40 nm from the surface to the base material side, and
   a sp2 component amount C2 and a sp3 component amount C3 in the first region exhibit a relationship of the following formula 1:

$$\{C2/(C2 + C3)\} \times 100 \leq 2.0 \text{ formula 1}$$

   C2 and C3 being measured using the method described in the description.

2. The cutting tool according to claim 1, wherein
   the sp2 component amount C2 and the sp3 component amount C3 in the first region exhibit a relationship of the following formula 2:

$$0.5 \leq \{C2/(C2 + C3)\} \times 100 \leq 2.0 \text{ formula 2.}$$

3. The cutting tool according to claim 1 or claim 2, wherein

   in the hard carbon film, an area percentage of black regions with an equivalent circle diameter of 10 nm or more is 0.7% or less, wherein
   the area percentage of black regions is measured in a high angle annular dark field scanning transmission electron microscope image of a cross section of the hard carbon film using the method described in the description.

4. The cutting tool according to any one of claim 1 to claim 3, wherein the hard carbon film has a thickness of 0.1 $\mu$m or more and 3.0 $\mu$m or less at a portion involved in cutting.

5. The cutting tool according to any one of claim 1 to claim 4, wherein the hard carbon film has a hydrogen content ratio of 5 atom% or less as measured using the method described in the description.

6. The cutting tool according to any one of claim 1 to claim 5, wherein the hard carbon film has a hydrogen content ratio of 4 atom% or less as measured using the method described in the description.

7. The cutting tool according to any one of claim 1 to claim 6, comprising an interface layer disposed between the base material and the hard carbon film,
   wherein the interface layer contains:

   at least one selected from the group consisting of a material made of one element selected from a first group consisting of Group 4 elements, Group 5 elements, Group 6 elements, Group 13 elements, and Group 14 elements excluding carbon in the Periodic Table, an alloy or first compound containing at least one element selected from the first group, and a solid solution derived from the first compound; or
   one or both of a second compound composed of at least one element selected from the first group and carbon, and a solid solution derived from the second compound, and

the interface layer has a thickness of 0.5 nm or more and less than 10 nm.

8. The cutting tool according to any one of claim 1 to claim 7, wherein the base material is composed of WC-based cemented carbide or cermet.

9. The cutting tool according to any one of claim 1 to claim 7, wherein the base material is composed of cubic boron nitride.

10. The cutting tool according to claim 1, wherein
a percentage of the sp2 component amount C2 with respect to a sum of the sp2 component amount C2 and sp3 component amount C3, {C2/(C2 + C3)} × 100, in the first region is 0.4 or more.

**Patentansprüche**

1. Schneidwerkzeug, das ein Basismaterial und einen auf dem Basismaterial angeordneten Film umfasst, wobei:

der Film einen harten Kohlenstofffilm auf seiner äußersten Oberfläche beinhaltet, wobei der harte Kohlenstofffilm diamantartiger Kohlenstoff oder amorpher Kohlenstoff ist,
der harte Kohlenstofffilm eine erste Region beinhaltet,
die erste Region eine Region ist, die zwischen einer Oberfläche des harten Kohlenstofffilms und einer imaginären Ebene P in einem Abstand von 40 nm von der Oberfläche zu der Seite des Basismaterials liegt, und
eine sp2-Komponentenmenge C2 und eine sp3-Komponentenmenge C3 in der ersten Region eine Beziehung der folgenden Formel 1 vorweisen:

$$\{C2/(C2 + C3)\} \times 100 \leq 2,0 \qquad \text{Formel 1}$$

wobei C2 und C3 unter Verwendung des in der Beschreibung beschriebenen Verfahrens gemessen werden.

2. Schneidwerkzeug nach Anspruch 1, wobei
die sp2-Komponentenmenge C2 und die sp3-Komponentenmenge C3 in der ersten Region eine Beziehung der folgenden Formel 2 vorweisen:

$$0,5 \leq \{C2/(C2 + C3)\} \times 100 \leq 2,0 \qquad \text{Formel 2}.$$

3. Schneidwerkzeug nach Anspruch 1 oder Anspruch 2, wobei

in dem harten Kohlenstofffilm ein Flächenprozentsatz von schwarzen Regionen mit einem äquivalenten Kreisdurchmesser von 10 nm oder mehr 0,7 % oder weniger beträgt, wobei
der Flächenprozentsatz der schwarzen Regionen in einem ringförmigen Hochwinkel-Dunkelfeld-Rastertransmissionselektronenmikroskopbild eines Querschnitts des harten Kohlenstofffilms unter Verwendung des in der Beschreibung beschriebenen Verfahrens gemessen wird.

4. Schneidwerkzeug nach einem von Anspruch 1 bis Anspruch 3, wobei der harte Kohlenstofffilm eine Dicke von 0,1 $\mu$m oder mehr und 3,0 $\mu$m oder weniger an einem Abschnitt aufweist, der am Schneidvorgang beteiligt ist.

5. Schneidwerkzeug nach einem von Anspruch 1 bis Anspruch 4, wobei der harte Kohlenstofffilm ein Wasserstoffgehaltsverhältnis von 5 Atom-% oder weniger aufweist, gemessen unter Verwendung des in der Beschreibung beschriebenen Verfahrens.

6. Schneidwerkzeug nach einem von Anspruch 1 bis Anspruch 5, wobei der harte Kohlenstofffilm ein Wasserstoffgehaltsverhältnis von 4 Atom-% oder weniger aufweist, gemessen unter Verwendung des in der Beschreibung beschriebenen Verfahrens.

7. Schneidwerkzeug nach einem von Anspruch 1 bis Anspruch 6, umfassend eine Grenzschicht, die zwischen dem Basismaterial und dem harten Kohlenstofffilm angeordnet ist,
wobei die Grenzschicht Folgendes enthält:

mindestens eines, das aus der Gruppe ausgewählt ist, die aus einem Material besteht, das aus einem Element hergestellt ist, das aus einer ersten Gruppe ausgewählt ist, die aus Elementen der Gruppe 4, der Gruppe 5, der Gruppe 6, der Gruppe 13 und der Gruppe 14 mit Ausnahme von Kohlenstoff im Periodensystem besteht, einer Legierung oder einer ersten Verbindung, die mindestens ein Element enthält, das aus der ersten Gruppe ausgewählt ist, und einer festen Lösung, die aus der ersten Verbindung abgeleitet ist; oder
eines oder beide aus einer zweiten Verbindung, die aus mindestens einem Element, das aus der ersten Gruppe ausgewählt ist, und Kohlenstoff zusammengesetzt ist, und einer festen Lösung, die aus der zweiten Verbindung abgeleitet ist, und
wobei die Grenzschicht eine Dicke von 0,5 nm oder mehr und 10 nm oder weniger aufweist.

8. Schneidwerkzeug nach einem von Anspruch 1 bis Anspruch 7, wobei das Basismaterial aus WC-basiertem Hartmetall oder Cermet zusammengesetzt ist.

9. Schneidwerkzeug nach einem von Anspruch 1 bis Anspruch 7, wobei das Basismaterial aus kubischem Bornitrid zusammengesetzt ist.

10. Schneidwerkzeug nach Anspruch 1, wobei
ein Prozentsatz der sp2-Komponentenmenge C2 in Bezug auf eine Summe aus der sp2-Komponentenmenge C2 und der sp3-Komponentenmenge C3, {C2/(C2 + C3)} x 100, in der ersten Region 0,4 oder mehr beträgt.

**Revendications**

1. Outil de coupe comprenant un matériau de base et un film disposé sur le matériau de base, dans lequel

le film inclut un film de carbone dur sur sa surface la plus extérieure, le film de carbone dur étant en carbone de type diamant ou en carbone amorphe,
le film de carbone dur inclut une première région,
la première région est une région prise en sandwich entre une surface du film de carbone dur et un plan imaginaire P à une distance de 40 nm depuis la surface jusqu'au côté matériau de base, et
le quantité de composant sp2 C2 et la quantité de composant sp3 C3 dans la première région présentent la relation de la formule 1 suivante :

$$\{C2/(C2 + C3)\} \times 100 \leq 2,0 \qquad \text{formule 1}$$

C2 et C3 étant mesurées au moyen du procédé décrit dans la description.

2. Outil de coupe selon la revendication 1, dans lequel
la quantité de composant sp2 C2 et la quantité de composant sp3 C3 dans la première région présentent la relation de la formule 2 suivante :

$$0,5 \leq \{C2/(C2 + C3)\} \times 100 \leq 2,0 \qquad \text{formule 2}$$

3. Outil de coupe selon la revendication 1 ou la revendication 2, dans lequel

dans le film de carbone dur, le pourcentage en superficie des régions noires ayant un diamètre de cercle équivalent de 10 nm ou plus est de 0,7 % ou moins, dans lequel
le pourcentage en superficie des régions noires est mesuré dans une image au microscope électronique à transmission et à balayage en champ sombre annulaire à angle élevé d'une section transversale du film de carbone dur par utilisation du procédé décrit dans la description.

4. Outil de coupe selon l'une quelconque des revendications 1 à 3, dans lequel le film de carbone dur a une épaisseur de 0,1 μm ou plus et 3,0 μm ou moins au niveau d'une portion impliquée dans la coupe.

5. Outil de coupe selon l'une quelconque des revendications 1 à 4, dans lequel le film de carbone dur a une teneur en hydrogène de 5 % atomiques ou moins, telle que mesurée au moyen du procédé décrit dans la description.

6. **Outil** de coupe selon l'une quelconque des revendications 1 à 5, dans lequel le film de carbone dur a une teneur en hydrogène de 4 % atomiques ou moins, telle que mesurée au moyen du procédé décrit dans la description.

7. Outil de coupe selon l'une quelconque des revendications 1 à 6, comprenant une couche d'interface disposée entre le matériau de base et le film de carbone dur,
   dans lequel la couche d'interface contient :

   au moins l'un choisi dans le groupe constitué par un matériau fait d'un seul élément choisi dans un premier groupe consistant en les éléments du Groupe 4, les éléments du Groupe 5, les éléments du Groupe 6, les éléments du Groupe 13, et les éléments du Groupe 14 à l'exclusion du carbone dans le Tableau Périodique, un alliage ou un premier composé contenant au moins un élément choisi dans le premier groupe, et une solution solide dérivée du premier composé ; ou
   l'un ou les deux parmi un deuxième composé qui est composé d'au moins un élément choisi dans le premier groupe et le carbone, et une solution solide dérivée du deuxième composé, et
   la couche d'interface a une épaisseur de 0,5 nm ou plus et inférieure à 10 nm.

8. Outil de coupe selon l'une quelconque des revendications 1 à 7, dans lequel le matériau de base est composé de cermet ou carbure cémenté à base de WC.

9. Outil de coupe selon l'une quelconque des revendications 1 à 7, dans lequel le matériau de base est composé de nitrure de bore cubique.

10. Outil de coupe selon la revendication 1, dans lequel
    le pourcentage de la quantité de composant sp2 C2 par rapport à la somme de la quantité de composant sp2 C2 et de la quantité de composant sp3 C3, $\{C2/(C2 + C3)\} \times 100$, dans la première région, est de 0,4 ou plus.

FIG.1

FIG.2

FIG.3

FIG.4

FIG.5

FIG.6

FIG.7

**EP 4 286 082 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003062706 A
- WO 2016190443 A
- JP 2007083382 A
- JP 2009006470 A